# EUROPEAN PATENT APPLICATION

(11) **EP 1 947 681 A2**
(43) Date of publication of application: **23.07.2008**
(21) Application number: 08250227.9
(22) Date of filing: 18.01.2008
(51) Int. Cl.: H01L 21/00

(54) **Single chamber, multiple tube high efficiency vertical furnace system**

(30) Priority: 18.01.2007 US 885420 P
(71) Applicant: Aviza Technology, Inc., Scotts Valley, CA 95066 (US)
(72) Inventor: May, Su, Fremont, CA 94539 (US); Yuh-Jia, Su, Cupertino, CA 95014 (US)
(74) Representative: Dunlop, Brian Kenneth Charles

(57) **Abstract**

A processing system is provided that has a single chamber in communication with multiple vertical processing tubes. The multiple tubes and boats are serviced by a single robotic substrate loading mechanism. A fluid supply feeds a fluid such as a gas or a vapor to at least one selectively isolatable portion of the system of the chamber, the boat loading area or one of the multiple vertical furnace processing tubes. With selective control of the atmosphere in the vertical processing tubes within the processing chamber, the wafers are processed so as to deposit or remove material therefrom. A single control panel and single gas panel servicing the system further adds to overall efficiency.

## Description

### CROSS REFERENCE TO RELATED APPLICATIONS

This application claims priority of United States Provisional Patent Application Serial No. 60/885,420 filed January 18, 2007, which is incorporated herein by reference.

### FIELD OF THE INVENTION

This invention relates in general to semiconductor wafer possessing systems, apparatuses, and methods, and in particular to the architecture for a high productivity vertical furnace system.

### BACKGROUND OF THE INVENTION

Thermal deposition devices have been used to form diffusion layers or deposition of polysilicon, silicon oxide or nitride films on silicon or glass substrates that are subsequently used in the manufacture of electronic devices. Wafers are commonly used as substrates and will be described in this application as a non-limiting example of substrate material used in this invention. Chemical vapor deposition (CVD) is the process of depositing solid material from a gaseous phase onto a wafer by means of a chemical reaction such as thermal decomposition, chemical oxidation, or chemical reduction. A non-limiting example of thermal decomposition involves the controlled deposition of organometallic compounds delivered to a reaction tube as a heated vapor that is reduced to elemental metal on the wafer surface. The CVD process can be used to deposit numerous elements including silicons, oxides, nitrides and carbides.

A thermal CVD system commonly employs a reaction chamber that houses a single reaction tube surrounded by heating elements wherein inert or reactive gases are introduced into the tube. Support of the wafers in the tube is accomplished by the use of a wafer boat that positions and holds the wafers in an ascending stacked arrangement with an upper wafer positioned directly above a lower wafer and separated by a distance sufficient to allow vapor flow between each wafer.

Efforts to increase production capacity and reduce floor space have used a multi-chamber module having a plurality of vertically stacked processing chambers each served by a dedicated atmospheric pressure front-end robot responsible for transporting wafers between a wafer cassette and its corresponding processing chamber. Increased production capacity has been achieved by combining a multiplicity of these individual chambers in a vertically stacked configuration and served by a common gas source. An example of this type apparatus is described by Savage, RN et al. (U.S. Patent Number 6,610,150) and herein incorporated by reference.

The disadvantages of the currently known systems is that they require numerous processing chambers each served by an individual loading robot that increases the complexity and cost of production and operation. Further, stacking multiple processing chambers on a common platform limits the per chamber wafer batch size thereby increasing production time and cost of production per wafer. Throughput is further hampered by the deposition downtime needed to adjust the loading chamber environment to conditions for accepting substrates and then to further adjust the processing chamber environment for delivery of the substrates for processing. Further, the use of numerous robotic wafer loading mechanisms to serve the numerous processing chambers increases the possibility of malfunction and service time to maintain a functional processing apparatus.

Thus, there exists a need for a single flexible CVD processing apparatus with the capability to simultaneously process large numbers of wafers at identical or unique conditions that is further coupled to a low-maintenance delivery system common to the entire processing system that can be used to select particular substrate from a common stock system.

### SUMMARY OF THE PRESENT INVENTION

A processing system is provided that has a single chamber in communication with multiple vertical processing tubes. The system includes a single processing chamber having multiple vertical processing tubes associated with the chamber. A boat loading area accommodates at least two substrate processing boats, the boat loading area being coupled to the single processing chamber. A single robotic substrate loading mechanism is provided for the transport of wafer substrates to one of the substrate boats. A fluid supply feeds a fluid such as a gas or a vapor to at least one selectively isolatable portion of the system of the chamber, the boat loading area or one of the multiple vertical furnace processing tubes.

A process for substrate processing is provided that includes loading substrates into one of multiple substrate processing boats and a boat loading area. The boat loading area is serviced by a single robotic substrate loading mechanism. One of the processing boats is then transferred from the boat loading area to the processing chamber. With selective control of the atmosphere in each of a plurality of vertical processing tubes within the processing chamber, the substrates are processed so as to deposit or remove material therefrom. Multiple tubes and boats are serviced by a single robotic substrate loading mechanism and a single control panel, and single gas panel process efficiency relative to single tube processing chambers each having devoted robotic substrate loading mechanisms, controllers, and gas panels.

### BRIEF DESCRIPTION OF THE DRAWINGS

Fig. 1 is a cross-sectional view of an inventive processing chamber depicting two wafer processing tubes housed in a single processing chamber with a single evacuation exhaust system servicing multiple processing tubes;

Fig. 2 is a schematic of a single gas panel supplying multiple tubes in an inventive processing chamber such as per Fig. 1 directed by a unified control system;

Fig. 3 is a schematic cross-sectional view of an inventive system such as per the preceding figures including a wafer processing area positioned above a wafer boat area serviced by a single wafer loading mechanism that transports substrate from a single service area to the wafer boat area or from the wafer boat area to a single product handling system wherein a single control system is used to direct wafer processing, wafer boat loading and unloading, the service system and the product handling system.

### DETAILED DESCRIPTION OF THE PREFERRED EMBODIMENTS

The present invention has utility as a vertical furnace system for the processing of semiconductor wafers used in the manufacture of electronic devices, flat panel display, optical, MEMS, or solar cell components. The present invention may be used for, but is not limited to, translation of semiconductor, glass or other substrate wafers within a near-atmospheric chemical vapor deposition (CVD) system, a rapid thermal oxidation system, or other furnace process applications.

A loadlock is also provided to facilitate frequent transfer of a substrate-loaded boat into inert gas environments.

A single processing chamber, multiple vertical tube system according to the present invention includes a single processing chamber coupled to multiple vertical processing tubes and a common exhaust conduit connected to a vacuum pump for regulating the atmospheric pressure within the processing chamber. The processing chamber also has a boat area containing multiple wafer substrate processing boats. The boats are transported by a pedestal raising mechanism from the boat area to the processing chamber. A common gas panel interconnected to a common fluid manifold is in fluid communication with each of the multiple processing tubes to independently adjust the atmosphere in each tube. A robotic wafer loading mechanism transports wafer substrates from a common stock to one of the wafer boats and removes processed wafer substrates. Preferably, a unified central processing unit provides control through electrical communication with valves, sensors, heating elements, motors, or the like associated with the processing chamber, the multiple processing tubes, the boat area, the robotic wafer loading mechanism, and the common gas panel.

An inventive method for simultaneously processing multiple substrates in a single chamber, multiple vertical tube system includes the loading of substrates from a substrate stock into one of multiple wafer processing boats in a boat area via a single robot wafer loading mechanism. A loaded boat containing at least one substrate is then transferred from the boat area to a processing chamber. The atmosphere in each of the multiple processing tubes coupled to the processing chamber is separately adjustable to expedite transfer of a boat between a tube and the common chamber. In this design a wafer batch is transitioning to or from a processing reaction in a chamber while another batch is simultaneously undergoing a processing reaction. After performing a treatment of substrates loaded in a boat within a tube, the atmosphere in the processing chamber is rendered compatible with the substrates based on the temperature and chemical reactivity of the substrate just processed and the boat is robotically moved to the boat area. Processed substrates are then robotically unloaded from the boat with the substrate loading mechanism and placed in a product handling system.

The present invention provides a complete production line system for processing of semiconductor substrates and methods for the use thereof. Various substrate processing protocols are performed using the present invention illustratively including near-atmospheric CVD, rapid oxidation processes, plasma enhanced chemical vapor deposition (CVD), high density plasma enhanced CVD, atomic layer deposition (ALD), and other furnace process applications. Should the present invention be used for CVD or ALD, it is appreciated that deposition processing pressures between 1x10⁻⁵ and 850 torr may be employed.

An inventive system includes a single processing chamber and multiple vertical processing tubes integrated into a system in which all tubes are serviced by a single gas panel and evacuation pumping system. It is appreciated that the single processing chamber is also coupled to a single boat area for loading and delivery in which a single robotic substrate loading system loads substrates onto multiple boats from a single substrate stock. Leveraging a common processing chamber and robotic loading mechanism with proper reaction process sequencing of wafer batches affords previously unattainable efficiencies of throughput, tool footprint, and equipment usage. The number of tubes coupled to the single chamber ranges from 2 to 100 tubes with typical operating tube numbers between 2 and 6. The processing chamber has a common access region where multiple substrate boats may be simultaneously or sequentially loaded into the chamber.

The single processing chamber is coupled to multiple processing tubes. Each such processing chamber is optionally surrounded by heating elements. Preferably, each processing tube accepts a single wafer carrier boat. An inventive system enhances productivity by placing substrate materials such as single wafers or wafer batches inside a furnace tube and maintaining them in a stationary stock position rather than sequentially transferring the substrates between different stations and thereby reducing the atmospheric changes as to pressure and composition associated with prior art systems. This attribute is beneficial in limiting unintended post-reaction modifications to the substrates associated with moving a still reactive (i.e. hot or ionically charged) substrate into an exchange processing chamber having a different atmosphere relative to the processing tube. Preferably, all processing tubes of an inventive system are serviced by a common gas panel and a single controller to save on equipment duplication and improve controller utilization. The present invention is used for the delivery of a fluid such as a gas or vapor associated with substrate process. The fluid is either inert or a reactant at processing tube operating temperature. Representative materials formed in the operation of an inventive system illustratively include silicon; silicon oxide; silicon oxynitride; silica nitride; metal silicates; metal oxides; metal nitrides; metal oxynitrides; metals such as copper, aluminum, tungsten, tantalum and gold. Through the use of a fluid manifold and mass flow controller in fluid communication with a gas jungle, each processing tube selectively receives fluid that is identical or different than that delivered to another tube processing with respect to pressure, composition, density, turbidity, temperature or combination of variable properties with process control by a unified gas panel and controller.

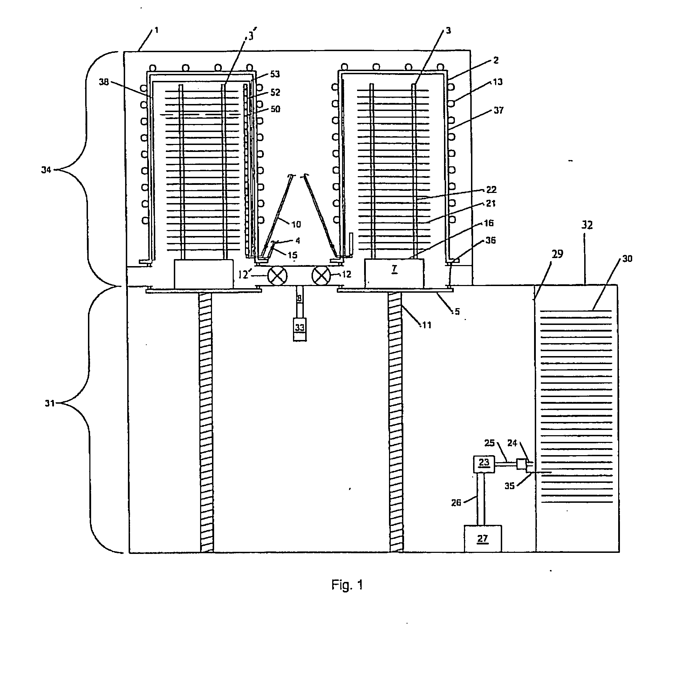

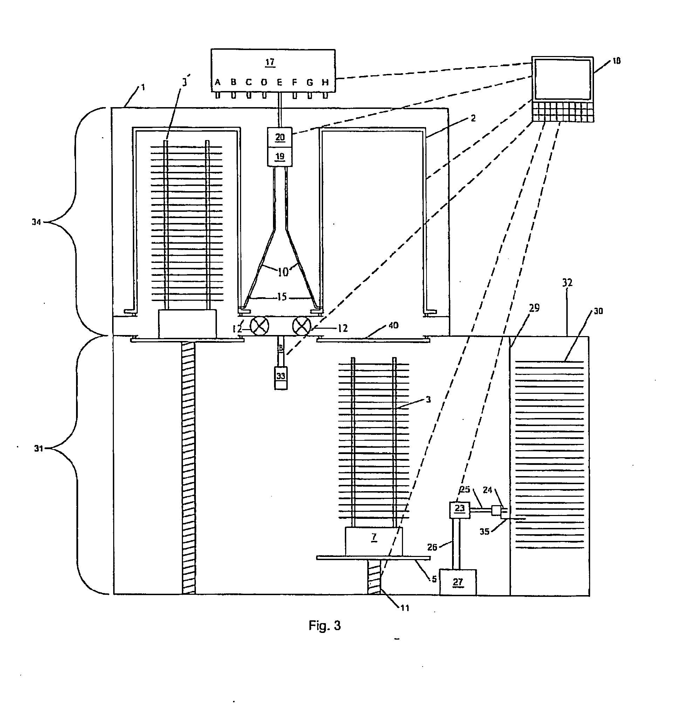

Referring now to Figs. 1 and 3, the major components of the present invention are exemplified by a process chamber area 34 that is defined within a processing chamber 1 that is positioned above a boat loading area 31 wherein a robotic substrate loading mechanism 23 serves to transfer wafer substrates from a common stock 30 to a substrate boat 3 or 3' movable between boat loading area 31 and processing chamber area 34. The stock system 30 has identical wafer substrates for large batch processing, or may be loaded with various wafer substrate stocks to be used in specialty or unique processing applications. The robotic wafer loading mechanism 23 also optionally serves to remove processed wafers and deliver them to a processed product holding holder 32. It is appreciated that the holder 32 is the locale of the common stock 30 as depicted with a batch of wafers being taken from stock 30 and processed wafers being returned thereto for removal upon opening the holder 32 or processed wafers being subjected to another processing reaction. Alternatively, two or more holders 32 are swapped into communication with boat loading area 31.

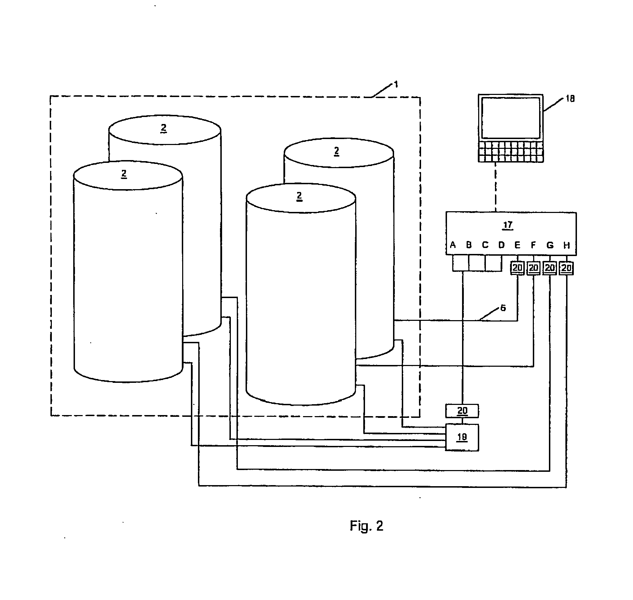

Fig. 1 is a cross-sectional view of a loaded two tube-single processing chamber 1. The chamber area 34 includes multiple wafer substrate vertical tubes 2. Optionally, each tube 2 is equipped with at least one of thermal control elements 13 for heating or cooling, a temperature sensor, a pressure sensor, and an inlet fluid ionization source. The chamber area 34 is bounded by a rigid chamber 1 made of materials common to the art and dependent on the processing chemistry to be performed in the chamber 1. Typically, the chamber 1 is formed of stainless steel, quartz, or ceramic, with quartz being most widely used in semiconductor manufacturing. The number of vertical tubes ranges from 2 to 100 dependent on the needs of the production facility. The chamber 1 optionally has a common exhaust conduit 8 connected to a vacuum pump 33 that serves in one mode of operation to simultaneously evacuate all tubes in the production chamber, simultaneously dramatically reducing processing time per boat compared to the existing tools. The exhaust conduit 8 is formed of materials known in the art suitable for support of reduced atmospheric pressures in the tube and illustratively includes quartz, SiC, polysilicon, and ceramic. Preferably, a vertical tube 2 has a selective isolation apparatus 12 that allows a tube 2 to be atmospherically isolated or individually evacuated to a desired pressure as determined by a single control system 18, as shown in Fig. 2. An adjustable isolation apparatus 12 uses conventional components such as a seal or a shutter. Preferably, a one-way valve is provided to an isolated tube to preclude backflow from the chamber 1 into a tube 2 upon a tube attaining a lower partial pressure relative to the chamber 1. The exhaust conduit and vacuum pump 33 are optionally located external to the loading area 31 or found therein.

The processing chamber 1 optionally has a materials import port 29 with an isolation apparatus 12' and with isolation apparatus 12 in combined operation provide for selectively isolating areas 31 and 34. It is appreciated that the capability of receiving multiple wafer boats 3 simultaneously into the chamber 1 offers the prospect of reducing processing time per substrate. The materials port 29 is of conventional construction and illustratively includes a hinged door, sliding opening, reticulated aperture, or other suitable structure known in the art capable of forming a vacuum seal. A substrate boat platform 5 that possesses a sealing gasket 36 produces a seal isolating a substrate boat 3 in a tube 2.

An inventive chamber 1 is coupled to between 2 and 100 vertical tubes 2. An exemplary configuration of an inventive system includes in a simplest form, two wafer boats robotically transferred to one of the two tubes. A single processing chamber according to the present invention in preferred form is coupled to 2 or 3 or 4 or more tubes, and containing from 2 to 4 substrate boats. Tubes are readily positioned around a central robotic feeding system or a tracked robotic loading system that moves to bring a boat into registry with a particular tube. Preferably, the number of boats is equal to or less than the number of tubes in a given inventive system. Through decreasing system downtime associated with boat transfer within a system, long processing routines and small batch processes are rendered viable based on throughput. Each tube 2 is independently cylindrical, rectangular or otherwise shaped to promote the processing of substrate as per the requirements of the operator and each tube is independently formed of metal, quartz, or other material based on the processing that will occur in a given tube. Each tube 2 has an outer shell 37. Optionally, a liner 38 is provided. Preferably, a fluid inlet 4 into the tube 2 provides a fluid flow from a series of vertically spaced orifices 50 in an injector 52. Alternative forms of injectors include a pipe having a terminal gas inlet opening with the pipe length extending to position the opening at any point along the vertical extent of the tube. With registry between an orifice 50 and a substrate positioned in a boat 3, across flow relative to a wafer is provided. Placement of an injector in a bulging liner section and/or axial rotation of an injector to control incident angle of a gas flow relative to wafer substrate center are operative in the context of the present invention. A teaching as to such a liner and injector is detailed in U.S. Patent Publication 2005/0098107. The liner 38 has an opening in the bottom thereof sized for accepting a wafer boat. Thermal control elements 13 are optionally provided to adjust inlet fluid temperature to a preselected value. A thermocouple 53 is optionally provided to yield thermal feedback control by way of a control system 18. Each tube 2 is optionally heated to temperatures in excess of 1250°C with the rate of temperature increase and cooling being regulated by a control system 18.

Each tube 2 is served by at least one fluid inlet conduit 4 or 10. While two such conduits are depicted proximal to boat 3' in Fig. 1, it is appreciated that any number of gas inlet conduits are provided commensurate with the number of inlets. A conduit is typically in fluid communication with a single injector or two conduits are combined to form an "h" injector or in other forms, having a common extent for fluid intermixing. The present invention is operative with a conventional gas handling jungle, illustratively inclusive of valving. 15. The gas delivery to each tube is regulated independent of, or identical to surrounding tubes allowing the operator to tailor the type of product produced in each tube depending on processing requirements.

A preferred architecture of an inventive system allows for a processing substrate boat 3 or a dummy substrate boat devoid of wafer substrate, to be loaded into a given tube 2. A conventional substrate boat 3 or 3' has at least one wafer support 21 positioned with sufficient space between each support 21 to allow for efficient and high quality processing of substrates. The distance between multiple substrate supports 21 is maintained by a set of wafer support rods 22. A boat 3 accommodates more than one wafer substrate and typically 1 to 200 substrates. At the bottom end of the stack of substrate supports is a wafer boat base 16 having a pedestal 7 on top of, and fixedly attached to a support platform 5. The pedestal is preferably complementary to the liner 38 of the mating tube 2 so as to control processing fluid flow. A wafer boat 3 is transferred into a tube 2 by a motor driven pedestal raising mechanism 11 that preferably is also controlled by the control system 18.

The substrate loading mechanism 23 has loading motor 27 that drives the mechanism as needed vertically, horizontally, or rotationally. The substrate loading mechanism 23 is fixedly connected to the substrate loading motor 27 by a substrate loading mechanism support rod 26. A substrate loading platform 24 moves on a substrate loading support arm 25 to reach the common stock system 30, the product holding system 32, and the boat loading area 31. The substrate loading platform includes one or more substrate transfer blades 35 for non-pitch-sensitive processes or non-filler wafer required processes. Optionally, a single substrate transfer blade is used for pitch-sensitive processes for the processes that need filler wafers to match wafer thermal mass.

Fig. 2 in particular depicts the processing chamber 1 and tubes 2 contained therein serviced by a single gas panel 17. The gas panel 17 typically meters multiple gases for various process applications. A tube 2 receives fluid flow as regulated by a gas divider 19 and mass flow controller 20 that are controlled by the control system 18 and balance the flow of fluids to each tube. Each tube 2 is connected to the gas panel 17 by a conventional gas jungle optionally including components such as preheaters, mass flow controllers, bubblers, filters and are depicted collectively at 6.

As shown in particular in Fig. 3, a wafer boat 3 or 3' having a pedestal 7 is stored in a boat area 31, where like numerals correspond to those used with respect to the aforementioned figures. Each wafer boat 3 or 3' is accessible by a robotic substrate loading mechanism 23 that is controlled by the control system 18.

Patent documents and publications mentioned in the specification are indicative of the levels of those skilled in the art to which the invention pertains. These documents and publications are incorporated herein by reference to the same extent as if each individual document or publication was specifically and individually incorporated herein by reference.

The foregoing description is illustrative of particular embodiments of the invention, but is not meant to be a limitation upon the practice thereof. The following claims, including all equivalents thereof, are intended to define the scope of the invention.

What is claimed is:

## Claims

1. A single chamber, multiple vertical tube substrate processing system comprising:
a single processing chamber;
a plurality of vertical processing tubes associated with said chamber;
a boat loading area accommodating at least two substrate processing boats, said boat loading area coupled to said chamber;
a single robotic substrate loading mechanism for transporting a plurality of substrates to one of said at least two substrate boats; and
a fluid supply selectively feeding a fluid to at least one of: said chamber, said boat area, and one of said plurality of vertical furnace processing tubes.

2. The system of claim 1 wherein said chamber contains at least two vertical processing tubes.

3. The system of claim 1 or 2 wherein said plurality of tubes is between 2 and 4 inclusive.

4. The system of any of the preceding claims further comprising a gas panel in fluid communication with said plurality of tubes.

5. The system of any of the preceding claims further comprising a liner adapted to reside in one of said plurality of tubes, said liner receiving one of said at least two substrate boats therein.

6. The system of any of the preceding claims wherein said single robotic substrate loading mechanism has a plurality of substrate engaging blades.

7. The system of any of the preceding claims further comprising a vertical injector having vertically displaced orifices aligned with a plurality of wafer supports of one of said at least two wafer boats inserted in the one of said plurality of tubes.

8. The system of any of the preceding claims further comprising a thermal control element surrounding one of said plurality of tubes.

9. The system of any of the preceding claims further comprising a control system controlling the simultaneous processing of a substrate mounted as a first boat of said at least two boats within one of said plurality of tubes and loading a second substrate into a second boat of said at least two boats.

10. The system of any of the preceding claims further comprising a pedestal raising mechanism elevating one of said at least two substrate boats between said single processing chamber and one of said plurality of vertical processing tubes.

11. The system of any of the preceding claims further comprising a common exhaust in fluid communication with said chamber.

12. The system of claim 4 wherein said gas panel selectively provides a different fluid flow to each of said plurality of tubes.

13. A process for substrate processing comprising:
loading substrates into one of multiple substrate processing boats in a boat loading area with a single robotic substrate loading mechanism;
transferring said one of multiple substrate processing boats from the boat loading area to a processing chamber; and
controlling the atmosphere in each of a plurality of vertical processing tubes for the substrate processing therein with a single controller and gas panel.

14. The process of claim 13 wherein substrates are being processed sequentially in at least two of said plurality of vertical processing tubes.

15. The process of claim 13 or 14 wherein wafer substrates are being processed in at least one of said plurality of vertical processing tubes simultaneously with said single robot substrate loading mechanism moving substrates within said boat area.

16. The process of claims 13 to 15 wherein the transferring said one of multiple substrate processing boats from the boat loading area to a processing chamber uses a motor driven pedestal raising mechanism.

17. The process of claims 13 to 16 further comprising isolating one of said plurality of vertical processing tubes with a first atmosphere and first temperature from said boat loading area having a second atmosphere and second temperature that differ from the first atmosphere and the first temperature.
